Europäisches Patentamt

European Patent Office

Office européen des brevets

(19)

(11) Numéro de publication : **0 001 461**
**B1**

(12) **FASCICULE DE BREVET EUROPÉEN**

(45) Date de publication du fascicule du brevet :
11.08.82

(51) Int. Cl.³ : **H 01 L 31/02**

(21) Numéro de dépôt : 78200193.7

(22) Date de dépôt : 18.09.78

(54) **Dispositif convertisseur d'énergie solaire en énergie électrique du genre comportant cellule photovoltaïque et concentrateur optique.**

(30) Priorité : 23.09.77 FR 7728777
23.09.77 FR 7728779

(43) Date de publication de la demande :
18.04.79 (Bulletin 79/08)

(45) Mention de la délivrance du brevet :
11.08.82 Bulletin 82/32

(84) Etats contractants désignés :
DE FR GB

(56) Documents cités :
FR A 1 336 135
FR A 2 054 773
FR A 2 362 408
US A 2 740 875
US A 4 024 852
US A 4 045 246

MECHANICAL ENGINEERING, vol. 87, nr. 7, juillet 1965 New York « Wide-Eyed » page 52

(73) Titulaire : **Laboratoires d'Electronique et de Physique Appliquée L.E.P.**
**3, Avenue Descartes**
**F-94450 Limeil-Brevannes (FR)**
**FR**
**N.V. Philips' Gloeilampenfabrieken**
**Pieter Zeemanstraat 6**
**NL-5621 CT Eindhoven (NL)**
**DE GB**

(72) Inventeur : **Bellugue, Jacques**
**SPID 209, rue de l'Université**
**F-75007 Paris (FR)**

(74) Mandataire : **Bonnefous, Jean et al**
**209, rue de l'Université**
**F-75007 Paris (FR)**

Imprimerie Jouve, 18, rue St-Denis, 75001 Paris, France

Dispositif convertisseur d'énergie solaire en énergie électrique du genre comportant cellule photovoltaïque et concentrateur optique

La présente invention concerne un dispositif de conversion d'énergie solaire en énergie électrique comportant une cellule photovoltaïque et des moyens optiques pour la concentration du rayonnement solaire sur la cellule et admettant un axe de révolution qui est l'axe de visée sur le centre du soleil.

La revue « Mechanical Engineering, Vol. 87 numéro 7 juillet 1965 New York, p. 52, colonne 3 » et la publication FR-A-2.054.773, décrivent chacun, un dispositif de conversion d'énergie solaire muni de moyens optiques pour la concentration du rayonnement solaire. Ces dispositifs sont de révolution autour d'un axe qui est l'axe de visée du dispositif sur le centre du soleil. Les moyens optiques de ces dispositifs sont constitués d'une lentille centrale et d'un miroir torique annulaire tous deux disposés du même côté que le soleil. Ces dispositifs ne sont pas proposés pour servir spécialement de convertisseur d'énergie solaire en énergie électrique. Aucun d'ailleurs n'est muni d'une cellule photo-électrique et selon la publication FR-A-2.054.773 il s'agit d'un four.

L'invention utilise des concentrateurs solaires de même type que selon l'art antérieur, précédemment cité, mais en combinaison avec des cellules photovoltaïques afin de diminuer, à égalité d'énergie captée, la surface réceptrice de ces cellules et obtenir un meilleur coût de l'énergie produite. Une telle utilisation se heurte à un certain nombre de difficultés que l'invention se propose de résoudre. L'une de ces difficultés se présente lorsque la cellule se trouve décalée dans son plan par rapport à la tache lumineuse fournie par le concentrateur, tache dont les dimensions et la forme sont, pour améliorer le rendement, généralement voisines de celles de la cellule. La cellule se trouve alors présenter une partie non éclairée, ce qui perturbe gravement son fonctionnement. Il convient, au contraire, d'éviter, lors de la captation de l'énergie solaire, qu'une partie de cellule soit dans l'obscurité. Le décalage de la tache lumineuse par rapport à la cellule est provoqué par le mouvement du soleil par rapport à la cellule. Le mouvement du soleil, notamment dans le cas d'une forte concentration de rayonnement sur la cellule, ne peut être suivi par voie mécanique, avec la précision requise, qu'à l'aide d'un système coûteux. Lors de ce mouvement, l'axe du système de poursuite risque d'être dépointé par rapport au centre du soleil. Si donc l'élément optique assurant la concentration de l'énergie solaire est de révolution et donne sur la cellule, en cas de pointage exact, une tache circulaire de mêmes dimensions que la surface réceptrice de cellule, également circulaire, une partie de cellule, en forme de croissant, se trouve être plongée dans l'obscurité en cas de dépointage.

Un remède porté, selon l'art antérieur, à une telle situation consiste à concentrer le rayonnement solaire selon une tache plus grande que la surface de la cellule. Il en résulte ainsi une tolérance de visée de l'axe du système, mais le rendement de la conversion de l'énergie solaire en énergie électrique est réduit. Ladite tolérance est plus faible à mesure que la concentration du rayonnement solaire est plus grande.

Une autre difficulté qui se présente en cas de concentration du rayonnement solaire sur une cellule photovoltaïque a trait au fait que cette dernière acquiert une température plus élevée qu'en l'absence de concentration. Or, on sait que le rendement d'une cellule photovoltaïque diminue à mesure que sa température augmente. En cas d'éclairage homogène de la cellule, l'on se heurte, de plus, au fait que la température de la cellule est plus élevée au centre que sur les bords, ce phénomène étant dû à ce que la chaleur provenant du centre s'évacue moins rapidement que celle provenant des bords.

La présente invention propose un dispositif de conversion d'énergie solaire en énergie électrique offrant une grande tolérance de pointage sur le centre du soleil, notamment dans le cas d'une forte concentration, de même qu'un éclairage de cellule favorable à ce que la température soit moins élevée au centre de la cellule que sur ses bords.

Le dispositif de conversion d'énergie solaire selon l'invention est du genre comportant une cellule photovoltaïque et des moyens optiques de concentration de lumière sur ladite cellule, le dispositif étant de révolution autour d'un axe qui est l'axe de visée du dispositif sur le centre du soleil. Il est remarquable en ce que les moyens optiques sont constitués d'une lentille centrale et d'un miroir torique annulaire, tous deux disposés du même côté que le soleil par rapport à la cellule photovoltaïque, le miroir torique formant, sur le plan de la cellule, une tache lumineuse annulaire de périphérie externe coïncidant, en cas de visée parfaite du soleil, avec la périphérie de la cellule, un secteur du miroir torique éclairant un secteur de la cellule opposé au premier par rapport à l'axe du dispositif, la lentille fournissant, pour sa part, une tache lumineuse coïncidant avec la surface de la cellule.

La structure du dispositif est telle qu'en cas de déplacement de la direction de son axe par rapport à la direction du rayonnement solaire, les taches lumineuses fournies respectivement par le miroir et la lentille se déplacent en sens opposés de façon que chaque partie de cellule soit constamment éclairée.

Du fait que les taches lumineuses en provenance respectivement du miroir et de la lentille et les énergies qu'elles contiennent sont indépendantes, il est possible, en agissant sur la génératrice du miroir torique et sur les caractéristiques, de la lentille, d'obtenir une énergie résultante concentrée sur la cellule répondant à une loi déterminée du centre vers les bords. Comme déjà indiqué, il est intéressant, pour des questions de température et de rendement de cellule, que cette loi corresponde à une énergie croissante du centre vers le bord. Cette croissance existe déjà pratiquement en ce qui concerne l'énergie concentrée par le miroir. Pour qu'il en soit de même pour l'énergie résultante, selon un mode de réalisation de l'invention, la lentille est conçue de façon qu'au centre de la tache lumineuse formée dans le plan de la cellule par cette lentille, l'énergie lumineuse soit plus petite que sur le bord.

De préférence, les rayons marginaux captés par le miroir torique font un angle de 45° avec l'axe après réflexion par ce miroir, de telle sorte que la sévérité à observer pour l'écart de visée soit minimale pour une baisse de rendement acceptable.

La description ci-après, en se référant au dessin annexé, le tout donné à titre d'exemple non limitatif, fera bien comprendre comment l'invention peut être réalisée.

La figure 1 montre en coupe une forme de réalisation d'un dispositif conforme à l'invention, pointé sur le soleil.

La figure 2 illustre la façon dont les taches lumineuses formées respectivement par la lentille et le miroir se déplacent par rapport à la cellule dans le cas d'une variation de la direction du rayonnement solaire.

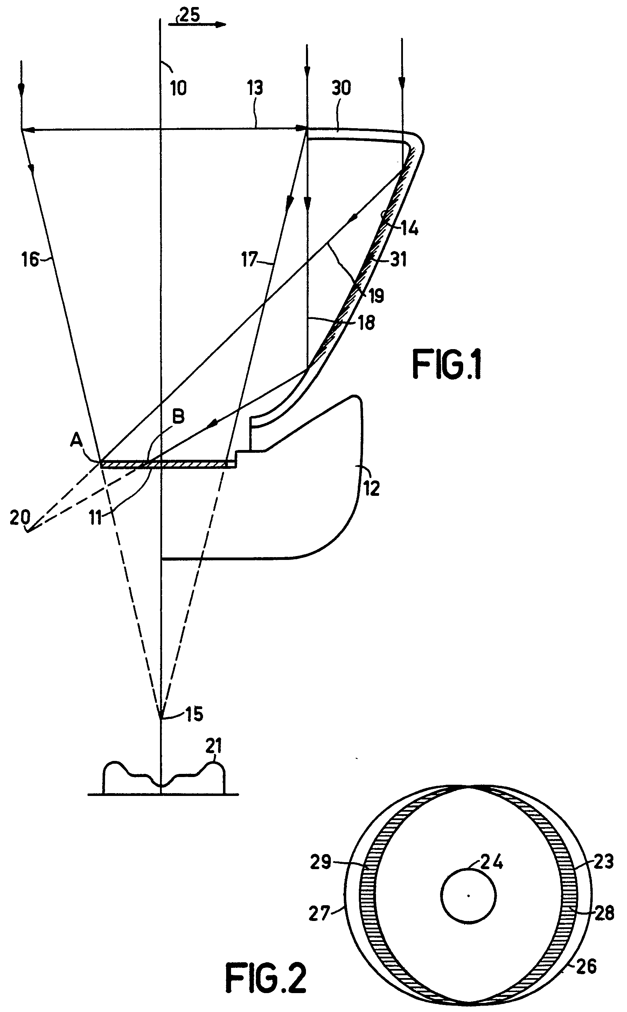

Sur la figure 1, l'axe de révolution du dispositif est représenté sous le repère numérique 10. Cet axe est orienté dans la direction du soleil. Sous 11 est représentée une cellule photovoltaïque éventuellement réunie au radiateur thermique 12 ; sous 13 est représentée une des parties du concentrateur, à savoir une lentille qui peut être une lentille de Fresnel ; l'autre partie du concentrateur est un miroir torique de révolution autour de 10 et dont la génératrice représentée en 14 peut être adaptée selon les besoins de la concentration, mais qui pourra, plus simplement, être une parabole. 13 et 14 se trouvent en avant de la cellule par rapport au soleil, en sorte que la face arrière de la cellule se trouve dans l'obscurité, donc dans les meilleures conditions pour évacuer la chaleur. La lentille 13 concentre la lumière sur la cellule, le point de rencontre au foyer 15 des rayons marginaux 16 et 17 se trouvant en arrière de cette dernière. De préférence, la lentille 13 est conçue de façon que l'énergie au centre de la tache lumineuse formée par cette lentille dans le plan de la cellule soit plus petite que sur le bord. Le miroir torique de génératrice 14 éclaire une couronne circulaire de ladite cellule, de telle sorte que chaque secteur de ce miroir éclaire un secteur de la couronne opposé à lui par rapport à l'axe du système, ceci afin que la partie du miroir la plus éloignée de l'axe réfléchisse les rayons incidents sur la partie de cellule également la plus éloignée de l'axe. Ainsi, sur la figure 1, le secteur de couronne de cellule éclairée par le faisceau de rayons marginaux 18 et 19 réfléchis par le miroir est, en coupe, le segment AB. Dans le cas où la génératrice 14 serait parabolique, son foyer serait en 20, point de concours des rayons marginaux 18 et 19. Un tel miroir torique présente nécessairement une caustique sur l'axe du système avec forte concentration d'énergie. C'est pourquoi les dimensions du miroir torique sont agencées de telle sorte que le faisceau en provenance du soleil n'éclaire que la couronne de la cellule, en évitant d'en éclairer le centre. Il est possible, en agissant sur la concentration de la lentille 13 et sur le profil 14 du miroir, d'obtenir, par la conjonction du miroir et de la lentille, une répartition d'énergie lumineuse sur la cellule répondant à une loi déterminée à l'avance du centre vers les bords, telle que celle représentée en coordonnées cartésiennes en 21, l'énergie étant indiquée suivant l'axe 10, sans cependant éviter qu'un petit cercle au voisinage de l'axe se trouve moins éclairé que la partie immédiatement voisine, ceci du fait que le miroir torique n'éclaire qu'une couronne. Suivant cette loi, l'énergie lumineuse croît du centre vers la périphérie de la cellule ce qui lui assure une évacuation convenable de la chaleur développée et, en conséquence, un rendement de conversion d'énergie lumineuse en énergie électrique élevé.

Sur la figure 2, on a représenté, dans le plan de la cellule, les taches lumineuses données respectivement par la lentille centrale et par le miroir torique, en cas de pointage parfait du système sur le soleil et en cas de dépointage de celui-ci. Sous le numéro 23 est indiqué le contour circulaire de la cellule. En cas de pointage parfait, la lentille donne une tache lumineuse dont la périphérie coïncide avec 23. La tache lumineuse en forme de couronne fournie par le miroir a pour limite extérieure le contour 23 et pour limite intérieure le cercle 24. En cas de dépointage dans le sens de la flèche 25 de la figure 1, la tache produite par la lentille devient 27, tandis que la limite extérieure de la tache produite par le miroir devient 26, la cellule restant constamment éclairée sur toute sa surface.

D'une façon préférentielle, on donne au miroir torique des dimensions telles que les rayons marginaux du faisceau capté (rayon 19 et son symétrique par rapport à 10) aient une inclinaison de 45° sur l'axe du système, de telle sorte que l'écart de visée permis soit maximal pour une baisse de rendement donnée.

D'une façon préférentielle et particulière, le diamètre extérieur du miroir et le diamètre de la lentille sont dans un rapport voisin de $\sqrt{2}$, de telle sorte que, en cas d'écart de visée, les deux petits croissants de cellule hachurés 28 et 29, non éclairés par l'un ou l'autre des éléments concentrateurs, reçoivent un éclairement moitié de celui reçu en cas de visée parfaite, ce qui est un écart tout à fait compatible avec un bon fonctionnement des cellules et assurant leur fiabilité.

Le dispositif selon la présente invention est particulièrement construit à la manière de celui faisant l'objet de la publication FR-A-2.404.306 (demande de brevet français au nom de la Demanderesse, déposée en France simultanément avec la présente demande). Le dispositif selon la présente invention prend la forme d'une ampoule d'éclairage ou d'un tube cathodique de télévision, la face avant comportant une lentille entourée d'une couronne plane ou non à faces parallèles 30, l'ensemble pouvant être obtenu par simple moulage du verre, le miroir torique du dispositif résultant de la métallisation d'une partie de la jupe 31 de l'ampoule, celle-ci étant construite en sorte que cette jupe ait une forme appropriée.

### Revendications

1. Dispositif de conversion d'énergie solaire en énergie électrique comportant une cellule photovoltaïque (11) et des moyens optiques pour la concentration du rayonnement solaire sur la cellule, le dispositif étant de révolution autour d'un axe (10) qui est l'axe de visée du dispositif sur le centre du soleil, caractérisé en ce que les moyens optiques sont constitués d'une lentille centrale (13) et d'un miroir torique annulaire (14), tous deux disposés du même côté que le soleil par rapport à la cellule photovoltaïque, le miroir torique formant, sur le plan de la cellule, une tache lumineuse annulaire de périphérie externe (23) coïncidant, en cas de visée parfaite du soleil, avec la périphérie de la cellule, un secteur du miroir torique éclairant un secteur de la cellule opposé au premier par rapport à l'axe du dispositif, la lentille fournissant, pour sa part, une tache lumineuse coïncidant avec la surface de la cellule.

2. Dispositif selon la revendication 1, caractérisé en ce que le miroir (14) a pour génératrice une parabole.

3. Dispositif selon la revendication 1 ou 2, caractérisé en ce que le diamètre extérieur du miroir (14) et le diamètre de la lentille (13) sont dans un rapport voisin de $\sqrt{2}$.

4. Dispositif selon la revendication 1, 2 ou 3, caractérisé en ce que la lentille (13) est conçue de façon qu'au centre de la tache lumineuse formée dans le plan de la cellule par cette lentille, l'énergie lumineuse soit plus petite que sur le bord.

5. Dispositif selon la revendication 1, 2, 3 ou 4, caractérisé en ce que la lentille (13) et le miroir (14) sont disposés dans une ampoule de verre ayant la forme d'un tube à rayons cathodiques, la lentille étant ménagée dans la face avant de l'ampoule et le miroir étant obtenu par métallisation d'une partie de la jupe (31) de l'ampoule.

### Claims

1. A device for the conversion of solar energy into electrical energy, comprising a photovoltaic cell (11) and optical means for concentrating the solar radiation onto the cell, the device being rotationally symmetrical about an axis (10) which is the axis of alignment of the device with the centre of the sun, characterized in that the optical means are constituted by a central lens (13) and by an annular thoric mirror (14) which are both disposed on the same side as the sun relative to the photovoltaic cell which thoric mirror forms an annular light spot, in the plane of the cell, whose outer circumference (23) coincides with the circumference of the cell in the case of correct alignment relative to the sum, a sector of the thoric mirror illuminating a sector of the cell which, relative to the axis of the device, is disposed opposite the said mirror sector, the lens forming a light spot which coincides with the surface area of the cell.

2. A device as claimed in Claim 1, characterized in that the generatrix of the mirror (14) is a parabola.

3. A device as claimed in Claim 1 or 2, characterized in that the outer diameter of the mirror (14) and the diameter of the lens (13) are in a ratio of approximately $\sqrt{2}$.

4. A device as claimed in Claim 1, 2 or 3, characterized in that the lens (13) is designed so that in the centre of the light spot formed by said lens in the plane of the cell the luminous energy is smaller than at the periphery.

5. A device as claimed in Claim 1, 2, 3 or 4, characterized in that the lens (13) and the mirror (14) are arranged in a glass bulb having the form of a cathode-ray tube, the lens being disposed in the front plane of the bulb and the mirror being obtained by metallisation of a part of the flare (31) of the bulb.

### Ansprüche

1. Einrichtung zum Umsetzen von Sonnenenergie in elektrische Energie, mit einem Fotoelement (11) und optischen Mitteln zum Zusammenführen der Sonnenstrahlung auf das Element, wobei die Einrichtung rotationssymmetrisch um eine Achse (10) ist, die die Visierachse der Einrichtung auf das Sonnenzentrum ist, dadurch gekennzeichnet, dass die optischen Mittel durch eine Zentrallinse (13) und einen ringförmigen thorischen Spiegel (14) gebildet werden, die beide an der gleichen Seite wie die Sonne in bezug auf dem Fotoelement angeordnet sind, dass der thorische Spiegel in der Ebene des Fotoelements einen ringförmigen Strahlungsfleck (23) bildet, dessen Aussenumfang bei guter Visiereinstellung auf die Sonnen sich mit dem Umfang des Elements deckt, dass ein Sektor des thorischen Spiegels einen in bezug auf die Achse der Einrichtung dem Spiegelsektor gegenüberliegenden Sektor des Elements anstrahlt, und dass die Linse selbst einen Strahlungsfleck bildet, der sich mit der Oberfläche des Elements deckt.

2. Einrichtung nach Anspruch 1, dadurch gekennzeichnet, dass der Spiegel (14) ein Parabel als Generatrix hat.

3. Einrichtung nach Anspruch 1 oder 2, dadurch gekennzeichnet, dass der Aussendurchmesser des Spiegels (14) und der Durchmesser der Linse (13) sich ungefähr als $\sqrt{2}$ verhalten.

4. Einrichtung nach Anspruch 1, 2 oder 3, dadurch gekennzeichnet, dass die Linse (13) derart ausgebildet ist, dass in der Mitte des in der Ebene des Elements von dieser Linse gebildeten Strahlungsflecks die Strahlungsintensität kleiner als am Rand ist.

5. Einrichtung nach Anspruch 1, 2, 3 oder 4, dadurch gekennzeichnet, dass die Linse (13) und der Spiegel (14) in einem Glaskolben in Form einer Kathodenstrahlröhre angeordnet sind, wobei die Linse in der Vorderfläche des Kolbens angebracht und der Spiegel durch Metallisierung eines Teils des Kolbenmantels (31) hergestellt ist.

0 001 461

FIG.1

FIG.2